# EUROPEAN PATENT APPLICATION

(11) **EP 2 581 942 A1**
(43) Date of publication of application: **17.04.2013**
(21) Application number: 11792329.2
(22) Date of filing: 01.06.2011
(51) Int. Cl.: H01L 31/04

(54) **SOLAR CELL**

(30) Priority: 09.06.2010 JP 2010132226
(71) Applicant: Sharp Kabushiki Kaisha, Osaka-shi, Osaka 545-8522 (JP)
(72) Inventor: YOKOSAWA, Yuhji, Osaka 545-8522 (JP); AKADA, Hiroyuki, Osaka 545-8522 (JP); NISHINO, Mitsutoshi, Osaka 545-8522 (JP)
(74) Representative: Müller - Hoffmann & Partner
(86) International application number: PCT/JP2011/062596
(87) International publication number: WO 2011/155372

(57) **Abstract**

A solar cell (1) including a silicon substrate (4), a textured structure (5) provided on a light-receiving surface of the silicon substrate (4), a light-receiving surface passivation film (13) provided on the textured structure (5), and an anti-reflection film (12) provided on the light-receiving surface passivation film (13), an average texture side length of the textured structure (5) being 7 µm or greater.

## Description

### TECHNICAL FIELD

The present invention relates to a solar cell, and particularly to a structure of a solar cell on a light-receiving surface.

### BACKGROUND ART

Expectations for solar cells for directly converting sunlight energy into electrical energy as a next-generation source of energy are rapidly growing in recent years, particularly from the standpoint of global environmental issues. While various types of solar cells including those using compound semiconductors and those using organic materials are known, solar cells using silicon crystals are the current mainstream.

As one of structural designs for a solar cell that uses a single crystal silicon substrate, there is a technique for forming, on a surface that is to serve as a light-receiving surface of the single crystal silicon substrate, a pyramidal concavo-convex shape, referred to as a textured structure, having differences in height from several micrometers to several tens of micrometers. By forming such a concavo-convex shape on the light-receiving surface of a solar cell, it is possible to increase the amount of light entering into the solar cell while reducing reflection of light incident on the light-receiving surface, thereby enhancing the photoelectric conversion efficiency of the solar cell.

Examples of means for forming a concavo-convex shape on a surface that is to serve as the light-receiving surface of a single crystal silicon substrate include a method wherein wet etching is performed with metal fine particles as a catalyst, and a method wherein reactive ion etching is performed. Neither of the methods, however, is preferable in terms of mass productivity and manufacturing cost. For this reason, as a general approach for forming a concavo-convex shape, a method is used wherein a surface that is to serve as the light-receiving surface of a single crystal silicon substrate is etched with an etchant obtained by adding a low-boiling-point alcohol solvent to an alkaline aqueous solution such as potassium hydroxide heated to not lower than 70°C and not higher than 90°C.

PTL 1 (WO2006/046601), for example, describes results of investigating the sizes of textured structures formed on single crystal silicon substrates, using alkaline etchants containing carboxylic acids.

### CITATION LIST

### PATENT LITERATURE

PTL 1: WO2006/046601

### SUMMARY OF INVENTION

### TECHNICAL PROBLEM

It was found that when textured structures were formed on surfaces of single crystal silicon substrates, and then the sizes of the textured structures were varied from one another, surface reflectances in the states of the single crystal silicon substrates did not significantly differ from one another. It was found, however, that when a solar cell was fabricated by forming a light-receiving surface passivation film and an anti-reflection film on each of these textured structures, the resulting solar cells showed surface reflectances differing from one another in magnitude, depending on the size of each textured structure.

In view of the above-described circumstances, an object of the present invention is to provide a solar cell with excellent characteristics, by lowering the surface reflectance of the light-receiving surface.

### SOLUTION TO PROBLEM

The present invention is directed to a solar cell including a silicon substrate, a textured structure provided on a light-receiving surface of the silicon substrate, a light-receiving surface passivation film provided on the textured structure, and an anti-reflection film provided on the light-receiving surface passivation film, an average texture side length of the textured structure being 7 µm or greater.

In the solar cell according to the present invention, the average texture side length is preferably 21 µm or smaller.

In the solar cell according to the present invention, the average texture side length is preferably 14 µm or smaller.

In the solar cell according to the present invention, a convex portion of the textured structure preferably has a height of 5 to 15 µm.

In the solar cell according to the present invention, the anti-reflection film is preferably thick near a bottom portion of the textured structure.

In the solar cell according to the present invention, the anti-reflection film is preferably titanium oxide.

In the solar cell according to the present invention, the anti-reflection film preferably contains 15 to 35% by mass of phosphorus as phosphorus oxide.

In the solar cell according to the present invention, the light-receiving surface passivation film is preferably silicon oxide.

In the solar cell according to the present invention, a light-receiving surface diffusion layer is preferably formed on the light-receiving surface of the silicon substrate.

### ADVANTAGEOUS EFFECTS OF INVENTION

In accordance with the present invention, a solar cell with excellent characteristics can be provided by lowering the surface reflectance of the light-receiving surface.

### BRIEF DESCRIPTION OF DRAWINGS

Fig. 1 is a schematic plan view of a back surface of a back electrode type solar cell according to an embodiment.
Fig. 2 (a) is a schematic cross-sectional view taken along line II-II in Fig. 1, Fig. 2 (b) is a schematic enlarged cross-sectional view of a portion of a light-receiving surface of an n-type silicon substrate shown in Fig. 2 (a), and Fig. 2 (c) is a schematic enlarged cross-sectional view illustrating a difference in thickness between an n⁺⁺ layer and a p⁺ layer shown in Fig. 2 (a).
Fig. 3 is a schematic plan view of a back surface of the n-type silicon substrate after removing an electrode for n-type, a electrode for p-type, and a back surface passivation film from the back electrode type solar cell according to the embodiment.
Figs. 4 (a) to (j) are schematic cross-sectional views illustrating an exemplary method for producing the back electrode type solar cell according to the embodiment.
Fig. 5 (a) is an exemplary SEM (Scanning Electron Microscope) image of the light-receiving surface of the back electrode type solar cell according to the embodiment, and Fig. 5 (b) is an SEM image of a light-receiving surface of a back electrode type solar cell according to a comparative example having an average texture side length of 4.6 µm.
Fig. 6 is a schematic enlarged plan view of one of pyramidal convex portions constituting a textured structure of a solar cell when viewed vertically downward from above.
Fig. 7 is a diagram showing results obtained by measuring surface reflectances of light-receiving surfaces of samples each obtained by forming a textured structure having a different average texture side length on the light-receiving surface of an n-type silicon substrate.
Fig. 8 is a diagram showing results obtained by measuring surface reflectances of light-receiving surfaces of back electrode type solar cells each fabricated by forming a light-receiving surface passivation film and an anti-reflection film on the textured structure on the light-receiving surface of any of the samples of n-type silicon substrates used in the measurement shown in Fig. 7.
Fig. 9 is a schematic side view of one of convex portions constituting a textured structure having a pyramidal concavo-convex shape.
Fig. 10 (a) is a schematic enlarged cross-sectional view of an exemplary light-receiving surface of a solar cell having a textured structure with a small texture side length, and Fig. 10 (b) is a schematic enlarged cross-sectional view of an exemplary light-receiving surface of a solar cell having a textured structure with a great texture side length.

### DESCRIPTION OF EMBODIMENTS

Embodiments of the present invention will be described hereinafter.

In the drawings of the present invention, the same or corresponding elements are denoted by the same reference characters.

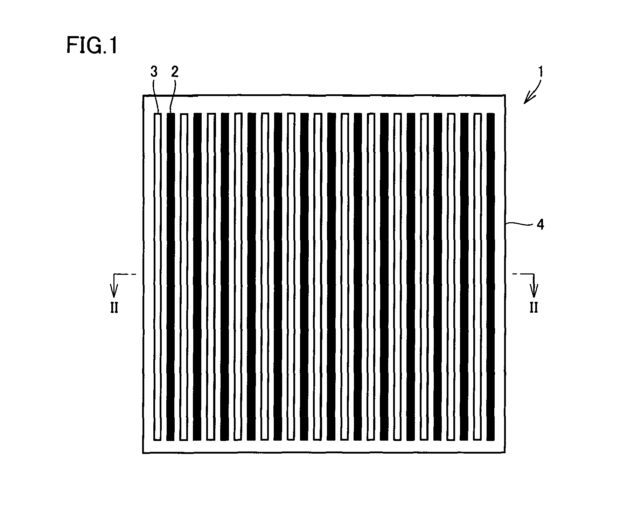

Fig. 1 is a schematic plan view of a back surface of a back electrode type solar cell according to an embodiment, which is an exemplary solar cell according to the present invention. Back electrode type solar cell 1 shown in Fig. 1 includes band-shaped electrodes for n-type 2 and band-shaped electrodes for p-type 3 on a back surface opposite to a light-receiving surface of an n-type silicon substrate 4, which is an n-type single crystal silicon substrate, and electrodes for n-type 2 and electrodes for p-type 3 are arranged alternately on the back surface of n-type silicon substrate 4.

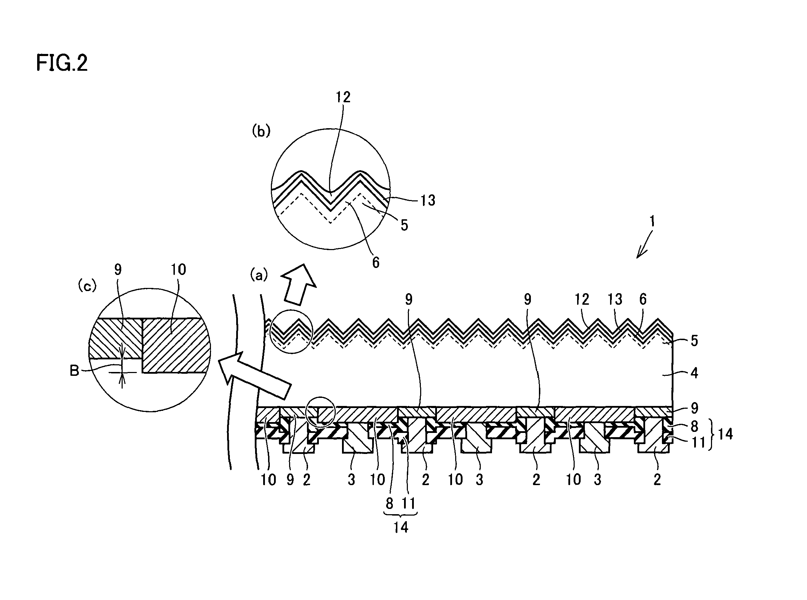

Fig. 2 (a) is a schematic cross-sectional view taken along line II-II in Fig. 1, Fig. 2 (b) is a schematic enlarged cross-sectional view of a portion of a light-receiving surface of n-type silicon substrate 4 shown in Fig. 2 (a), and Fig. 2 (c) is a schematic enlarged cross-sectional view illustrating a difference in thickness between an n++ layer and a p+ layer shown in Fig. 2 (a). As shown in Figs. 2 (a) and (b), a concavo-convex shape 5 (textured structure) is formed on the light-receiving surface of n-type silicon substrate 4. The concavo-convex portion of concavo-convex shape 5 is of the order of from several to tens of micrometers, for example.

Moreover, as shown in Figs. 2 (a) and (b), an n+ layer 6, which is a light-receiving surface diffusion layer formed by diffusion of an n-type impurity over the entire light-receiving surface of n-type silicon substrate 4, is formed as an FSF (Front Surface Field) layer, a light-receiving surface passivation film 13 is formed on n+ layer 6, and an anti-reflection film 12 is formed on light-receiving surface passivation film 13.

N+ layer 6 serving as the light-receiving surface diffusion layer has an n-type impurity concentration higher than that in n-type silicon substrate 4.

Light-receiving surface passivation film 13 is made of a silicon oxide film. Light-receiving surface passivation film 13 has a thickness of 15 to 200 nm, and preferably has a thickness of 15 to 60 nm.

Anti-reflection film 12 contains an n-type impurity having n-type conductivity identical in conductivity type to n-type silicon substrate 4, and is made of, for example, a titanium oxide film containing phosphorus as an n-type impurity. Anti-reflection film 12 has a thickness of 10 to 400 nm, for example. A portion of anti-reflection film 12 near a bottom portion of concavo-convex shape 5 (textured structure) is thicker than other portions thereof.

Phosphorus in anti-reflection film 12 is present as phosphorus oxide in an amount of 15 to 35% by mass of anti-reflection film 12. The expression that phosphorus is present as phosphorus oxide in an amount of 15 to 35% by mass of anti-reflection film 12 means that the amount of phosphorus oxide contained in anti-reflection film 12 is 15 to 35% by mass of the entire anti-reflection film 12.

Moreover, as shown in Fig. 2 (a), on the back surface of n-type silicon substrate 4, a back surface passivation film 14 is formed that is made of a two-layered structure in which a second back surface passivation film 8 and a first back surface passivation film 11 are stacked in this order from the n-type silicon substrate 4-side.

Furthermore, an n⁺⁺ layer 9 serving as an n-type impurity diffusion layer and a p⁺ layer 10 serving as a p-type impurity diffusion layer are formed alternately adjacent to each other on the back surface of n-type silicon substrate 4. Since n⁺⁺ layer 9 and p⁺ layer 10 are thus formed alternately adjacent to each other, when a reverse bias (reverse bias voltage) is applied to back electrode type solar cell 1, a phenomenon occurs in which almost no current flows until a breakdown voltage is reached, and when a voltage greater than the breakdown voltage is applied, a large current (breakdown current) flows and a voltage higher than that is not applied to back electrode type solar cell 1, as in a common diode. Since this breakdown voltage flows in a region where n⁺⁺ layer 9 and p⁺ layer 10 are adjacent to each other, current flows in the entire back surface of back electrode type solar cell 1, wherein n⁺⁺ layer 9 and p⁺ layer 10 are formed alternately adjacent to each other. Thus, voltage is not applied to some portions of back electrode type solar cell 1, which avoids generation of heat due to local leakage of current.

As shown in Fig. 2 (c), n⁺⁺ layer 9 has a surface located at a depth shallower than a surface of p⁺ layer 10 by a depth B, the surface of n⁺⁺ layer 9 on the back surface-side of n-type silicon substrate 4 is more recessed than surfaces of regions other than n⁺⁺ layer 9 on the back surface-side of n-type silicon substrate 4, and n⁺⁺ layer 9 and p⁺ layer 10 are disposed to form a concave shape. Depth B is of the order of several tens of nanometers, for example. Furthermore, electrode for n-type 2 is formed on n⁺⁺ layer 9, and electrode for p-type 3 is formed on p⁺ layer 10.

There is a difference in thickness between back surface passivation film 14 on n⁺⁺ layer 9 and back surface passivation film 14 on p⁺ layer 10, and back surface passivation film 14 on n⁺⁺ layer 9 has a thickness larger than that of back surface passivation film 14 on p⁺ layer 10.

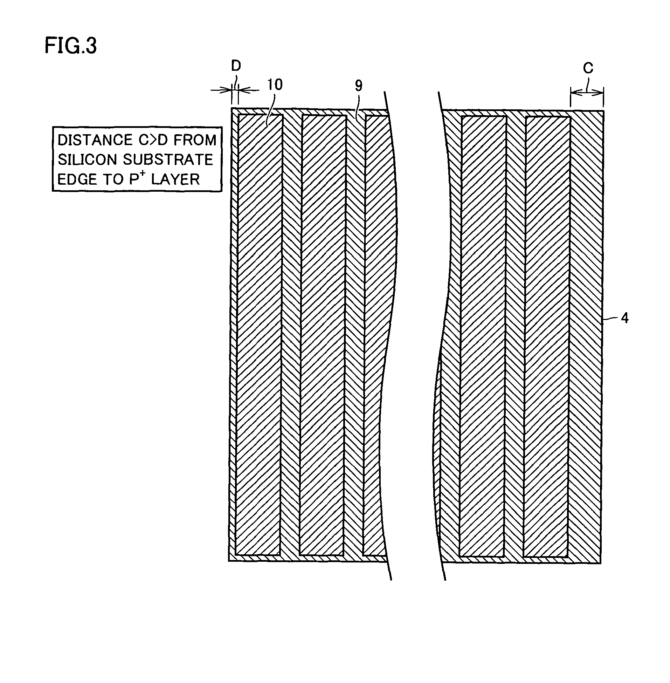

Fig. 3 shows a schematic plan view of the back surface of n-type silicon substrate 4 after removing electrode for n-type 2, electrode for p-type 3, and back surface passivation film 14 from back electrode type solar cell 1. In back electrode type solar cell 1 according to the embodiment, n⁺⁺ layer 9 is formed on an outer peripheral edge of the back surface of n-type silicon substrate 4.

N⁺⁺ layer 9, which is the n-type impurity diffusion layer having n-type conductivity type identical in conductivity type to n-type silicon substrate 4, is formed on the outer peripheral edge of the back surface of n-type silicon substrate 4, and therefore, even where the surface of n⁺⁺ layer 9 on the outer peripheral edge of the back surface of n-type silicon substrate 4 is removed under some influence to make the silicon surface of n-type silicon substrate 4 exposed, or where n⁺⁺ layer 9 has run into a side surface and/or the light-receiving surface of n-type silicon substrate 4, n⁺⁺ layer 9 is brought into contact with the surface of the same conductivity type. Since no leakage current occurs in a portion of contact between surfaces of the same conductivity type, occurrence of a leakage current at the time of application of a reverse bias (reverse bias voltage) to back electrode type solar cell 1 can be suppressed.

It is noted that characteristics of back electrode type solar cell 1 do not significantly deteriorate even if n⁺⁺ layer 9 is not formed on the entire outer peripheral edge of the back surface of n-type silicon substrate 4, and therefore, p⁺ layer 10, which is a p-type impurity diffusion layer different in conductivity type from n-type silicon substrate 4, may be partially formed on the outer peripheral edge of the back surface of n-type silicon substrate 4.

Where the light-receiving surface diffusion layer, n⁺ layer 6, is not formed, n⁺⁺ layer 9 need not be formed on the outer peripheral edge of the back surface of n-type silicon substrate 4.

Moreover, as shown in Fig. 3, a distance from an edge of n-type silicon substrate 4 to p⁺ layer 10 (distance orthogonal to a longitudinal direction of p⁺ layer 10) on the right side of n-type silicon substrate 4 is defined by C, and that on the left side of n-type silicon substrate 4 is defined by D, with C and D satisfying the relation of C>D. Hence, width C of n⁺⁺ layer 9 on the outer peripheral edge of the right side of n-type silicon substrate 4 is different from width D of n⁺⁺ layer 9 on the outer peripheral edge of the left side of n-type silicon substrate 4. As shown in Fig. 2 (a), in the present embodiment, electrode for n-type 2 is also formed on n⁺⁺ layer 9 having width C on the outer peripheral edge of the right side of n-type silicon substrate 4, as it is formed on n⁺⁺ layer 9 sandwiched between p⁺ layers 10.

Furthermore, as shown in Fig. 3, all regions of n⁺⁺ layer 9 are connected to form a single diffusion layer region on the back surface of n-type silicon substrate 4. P⁺ layers 10 are individually formed in the form of islands, and each individual island-like p⁺ layer 10 is surrounded with n⁺⁺ layer 9.

A total area of n⁺⁺ layer 9 on the back surface of n-type silicon substrate 4 is preferably smaller than a total area of p⁺ layers 10. In this case, back electrode type solar cell 1 tends to provide a greater short-circuit current.

In the foregoing, n⁺⁺ layer 9 may be separated in the direction orthogonal to the longitudinal direction of p⁺ layer 10 in at least one position of n⁺⁺ layer 9. In this case, p⁺ layer 10 is formed between separated n⁺⁺ layers 9.

Moreover, in the foregoing, p⁺ layer 10 may be separated in the direction orthogonal to the longitudinal direction of p⁺ layer 10 in at least one section of p⁺ layer 10. In this case, n⁺⁺ layer 9 is formed between separated p⁺ layers 10.

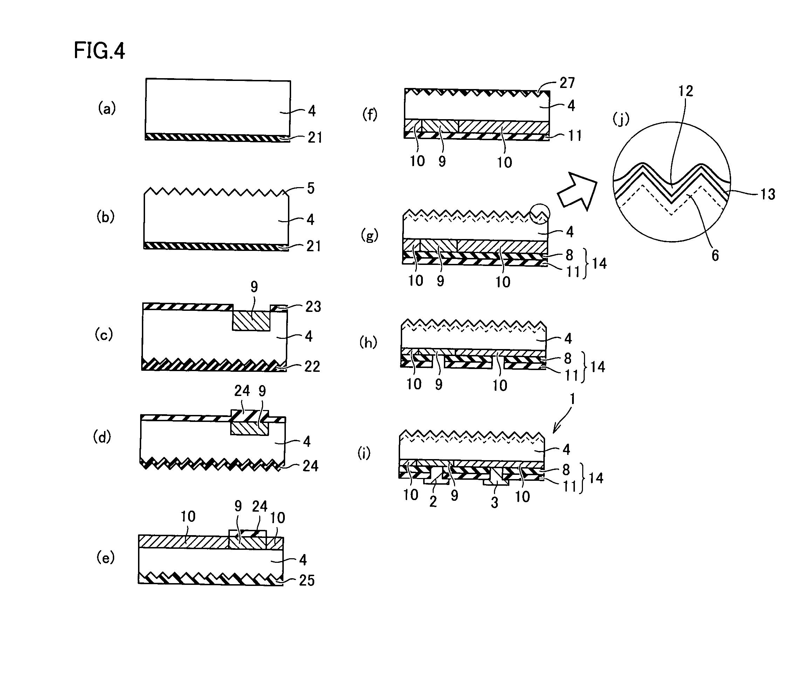

Referring to the schematic cross-sectional views in Figs. 4 (a) to (j), an exemplary method for producing the back electrode type solar cell according to the embodiment will be described hereinafter.

Initially, as shown in Fig. 4 (a), a texturing mask 21 is formed on the back surface (back surface of n-type silicon substrate 4) opposite to the surface that is to serve as the light-receiving surface of n-type silicon substrate 4 (light-receiving surface of n-type silicon substrate 4). Here, a substrate made of 100 µm thick n-type single crystal silicon, for example, can be used as n-type silicon substrate 4. A silicon nitride film, for example, can be used as texturing mask 21. Texturing mask 21 can be formed by CVD (Chemical Vapor Deposition) or sputtering, for example.

Next, as shown in Fig. 4 (b), concavo-convex shape 5 is formed on the light-receiving surface of n-type silicon substrate 4. Concavo-convex shape 5 may be a textured structure, for example. Concavo-convex shape 5 can be formed by, for example, etching the light-receiving surface of n-type silicon substrate 4 with a solution obtained by adding isopropyl alcohol to an alkaline aqueous solution, such as an aqueous solution of sodium hydroxide or an aqueous solution of potassium hydroxide, and heating the mixture to not lower than 70°C and not higher than 80°C.

Next, as shown in Fig. 4 (c), n⁺⁺ layer 9 is formed on a portion of the back surface of n-type silicon substrate 4. Here, n⁺⁺ layer 9 can be formed as follows, by way of example.

Initially, texturing mask 21 on the back surface of n-type silicon substrate 4 is removed. A diffusion mask 22, for example, a silicon oxide film, is next formed on the light-receiving surface of n-type silicon substrate 4. A diffusion mask 23 is next formed by applying a masking paste to a region of the back surface of n-type silicon substrate 4 except for the region where n⁺⁺ layer 9 is to be formed, and then heat-treating the masking paste. Then, phosphorus is diffused into a section where the back surface of n-type silicon substrate 4 is exposed through diffusion mask 23 by vapor phase diffusion using POCl₃, thereby forming n⁺⁺ layer 9.

A masking paste containing a solvent, a thickener, and a silicon oxide precursor, for example, may be used as the masking paste. Inkjet printing or screen printing, for example, may be used as the method of applying the masking paste.

Next, as shown in Fig. 4 (d), a silicon oxide film 24 is formed on the back surface and the light-receiving surface of n-type silicon substrate 4. Here, silicon oxide film 24 can be formed by, for example, removing diffusion mask 22 and diffusion mask 23 formed on n-type silicon substrate 4, and a glass layer formed by diffusion of phosphorus into diffusion masks 22, 23, by hydrofluoric acid treatment, followed by thermal oxidation with oxygen or water vapor. The thermal oxidation of n-type silicon substrate 4 with oxygen or water vapor can be carried out by performing heat treatment with n-type silicon substrate 4 being placed in an oxygen atmosphere or a water vapor atmosphere.

Here, as shown in Fig. 4 (d), the thickness of silicon oxide film 24 on the region where n⁺⁺ layer 9 is formed on the back surface of n-type silicon substrate 4 (silicon oxide film 24 on n⁺⁺ layer 9) can be made larger than that of silicon oxide film 24 on the region where n⁺⁺ layer 9 is not formed (silicon oxide film 24 on the region other than n⁺⁺ layer 9). In one example of a case for allowing formation of silicon oxide film 24 having such a shape, when silicon oxide film 24 is formed by carrying out thermal oxidation with water vapor at 900°C, silicon oxide film 24 on n⁺⁺ layer 9 can have a thickness of 250 to 350 nm, and silicon oxide film 24 on the region other than n⁺⁺ layer 9 can have a thickness of 70 to 90 nm. Here, the phosphorus concentration in the surface of n⁺⁺ layer 9 before thermal oxidation is 5 x 10¹⁹/cm³ or higher, and the range of treatment temperatures for thermal oxidation with oxygen is from 800 to 1000°C, and that for thermal oxidation with water vapor is from 800 to 950°C.

Since the thickness of a diffusion mask for n⁺⁺ layer 9 at the time of formation of p⁺ layer 10 in the below-described step is preferably 60 nm or larger, the difference in thickness between silicon oxide film 24 on n⁺⁺ layer 9 and silicon oxide film 24 on the region other than n⁺⁺ layer 9 is preferably 60 nm or greater.

Furthermore, when forming silicon oxide film 24 by thermal oxidation, the growth rate of silicon oxide film 24 by thermal oxidation can be varied depending on the type and concentration of the impurity to be diffused into the back surface of n-type silicon substrate 4, and in particular, where the n-type impurity concentration in the back surface of n-type silicon substrate 4 is high, the growth rate of silicon oxide film 24 can be high. Therefore, the thickness of silicon oxide film 24 on n⁺⁺ layer 9 where the n-type impurity concentration is higher than that in n-type silicon substrate 4 can be made larger than the thickness of silicon oxide film 24 on the region other than n⁺⁺ layer 9 where the n-type impurity concentration is lower than that in n⁺⁺ layer 9.

Silicon oxide film 24 is formed by bonding of silicon and oxygen during thermal oxidation.

Next, as shown in Fig. 4 (e), a p⁺ layer 10 is formed on a portion of the back surface of n-type silicon substrate 4. Here, p⁺ layer 10 can be formed as follows, by way of example.

Initially, silicon oxide film 24 on the light-receiving surface of n-type silicon substrate 4 and silicon oxide film 24 on the region other than n⁺⁺ layer 9 on the back surface of n-type silicon substrate 4 are removed by etching. Here, since the thickness of silicon oxide film 24 on n⁺⁺ layer 9 of the back surface of n-type silicon substrate 4 is larger than that of silicon oxide film 24 on the region other than n⁺⁺ layer 9, silicon oxide film 24 can be left solely on n⁺⁺ layer 9 of the back surface of n-type silicon substrate 4. Owing to the difference in etching rate between silicon oxide film 24 on n⁺⁺ layer 9 and silicon oxide film 24 on the region other than n⁺⁺ layer 9, the thickness of silicon oxide film 24 on n⁺⁺ layer 9 can be about 120 nm.

For example, when silicon oxide film 24 is formed by 30 minutes of thermal oxidation with water vapor at 900°C, and hydrofluoric acid treatment is performed to remove silicon oxide film 24 on the region other than n⁺⁺ layer 9, the thickness of silicon oxide film 24 on n⁺⁺ layer 9 can be about 120 nm. As described above, when the thickness of silicon oxide film 24 on n⁺⁺ layer 9 is 60 nm or larger, silicon oxide film 24 can suitably function as a diffusion mask during formation of p⁺ layer 10.

A diffusion mask 25, for example, a silicon oxide film, is subsequently formed on the light-receiving surface of n-type silicon substrate 4, and a solution obtained by dissolving a polymer formed by reacting an organic polymer with a boron compound in an aqueous solution of an alcohol is applied to the back surface of n-type silicon substrate 4 and dried, and subsequently, boron is diffused into the region other than n⁺⁺ layer 9 by carrying out heat treatment, thereby forming p⁺ layer 10.

Next, as shown in Fig. 4 (f), first back surface passivation film 11 is formed on the back surface of n-type silicon substrate 4. Here, first back surface passivation film 11 can be formed as follows, by way of example.

Initially, silicon oxide film 24 and diffusion mask 25 formed on n-type silicon substrate 4, and a glass layer formed by diffusion of boron into silicon oxide film 24 and diffusion mask 25 are removed by hydrofluoric acid treatment.

Next, first back surface passivation film 11 also serving as a diffusion mask, such as a silicon oxide film, is formed on the back surface of n-type silicon substrate 4 by CVD, or by applying and firing SOG (spin on glass), for example.

Next, a mixture 27 containing at least a phosphorus compound, a titanium alkoxide, and an alcohol is applied to the light-receiving surface of n-type silicon substrate 4 by spin coating or the like and dried. Here, mixture 27 is applied to form n+ layer 6, which is the light-receiving surface diffusion layer, on the light-receiving surface of n-type silicon substrate 4, and also form a titanium oxide film that is to serve as anti-reflection film 12. Phosphorus pentoxide, for example, can be used as the phosphorus compound of mixture 27, tetraisopropyl titanate, for example, can be used as the titanium alkoxide, and isopropyl alcohol, for example, can be used as the alcohol.

Next, as shown in Figs. 4 (g) and (j), n+ layer 6 and anti-reflection film 12 are formed on the light-receiving surface of n-type silicon substrate 4. Here, each of n⁺ layer 6 and anti-reflection film 12 can be formed by heat-treating mixture 27 that has been applied to the light-receiving surface of n-type silicon substrate 4 and dried. As a result of this heat treatment, phosphorus as the n-type impurity is diffused into the light-receiving surface of n-type silicon substrate 4, thereby forming n+ layer 6 on the entire light-receiving surface of n-type silicon substrate 4, and also forming the titanium oxide film containing phosphorus that is to serve as anti-reflection film 12. N⁺ layer 6 after the heat treatment has a sheet resistance value of 30 to 150 Ω/□, and desirably 80 ± 20 Ω/□.

Next, as shown in Figs. 4 (g) and (j), second back surface passivation film 8 is formed on the back surface of n-type silicon substrate 4, and light-receiving surface passivation film 13 is also formed on n+ layer 6 on the light-receiving surface of n-type silicon substrate 4. Here, each of second back surface passivation film 8 and light-receiving surface passivation film 13 can be formed as follows, by way of example.

Thermal oxidation of n-type silicon substrate 4 with oxygen or water vapor is carried out. As a result, second back surface passivation film 8 made of a silicon oxide film is formed between the back surface of n-type silicon substrate 4 and first back surface passivation film 11, and light-receiving surface passivation film 13 made of a silicon oxide film is also formed between n+ layer 6 on the light-receiving surface of n-type silicon substrate 4 and anti-reflection film 12.

The reason why light-receiving surface passivation film 13 is formed between n+ layer 6 and anti-reflection film 12 is believed to be that anti-reflection film 12 develops a crack due to an increased thickness of anti-reflection film 12 on the concave portion of concavo-convex shape 5 on the light-receiving surface, and oxygen or water vapor enters through the section where the crack is formed, whereby the silicon oxide film, that is, light-receiving surface passivation film 13, is grown. It is also believed that because the thickness of anti-reflection film 12 is small on the convex portion of concavo-convex shape 5 on the light-receiving surface, oxygen or water vapor permeates therethrough, whereby the silicon oxide film, that is, light-receiving surface passivation film 13, is grown.

Furthermore, the reason why second back surface passivation film 8 is formed between the back surface of n-type silicon substrate 4 and first back surface passivation film 11 is believed to be that because first back surface passivation film 11 on the back surface of n-type silicon substrate 4 is a film formed by CVD or the like, oxygen or water vapor permeates into first back surface passivation film 11, whereby the silicon oxide film, that is, second back surface passivation film 8, is grown.

Second back surface passivation film 8 and light-receiving surface passivation film 13 can also be formed subsequent to the heat treatment for forming the light-receiving surface diffusion layer, i.e., n⁺ layer 6, and anti-reflection film 12, by changing the gas and carrying out thermal oxidation with oxygen or water vapor.

Next, as shown in Fig. 4 (h), portions of back surface passivation film 14 are removed, so that a portion of n⁺⁺ layer 9 and a portion of p⁺ layer 10 become exposed through back surface passivation film 14. Here, the portions of back surface passivation film 14 can be removed by, for example, applying an etching paste to the portions of back surface passivation film 14 by screen printing or the like, and then heating the etching paste. The etching paste can then be removed by, for example, performing acid treatment following ultrasonic cleaning. An etching paste containing at least one selected from the group consisting of phosphoric acid, hydrogen fluoride, ammonium fluoride, and ammonium hydrogen fluoride as an etching component, and also containing water, an organic solvent, and a thickener, can be used, for example, as the etching paste.

Next, as shown in Fig. 4 (i), electrode for n-type 2 is formed on n⁺⁺ layer 9, and electrode for p-type 3 is formed on p⁺ layer 10. Here, each of electrode for n-type 2 and electrode for p-type 3 can be formed by, for example, applying a silver paste to a predetermined position of back surface passivation film 14 by screen printing, and then drying, followed by firing the silver paste. As a result, back electrode type solar cell 1 according to the embodiment can be produced.

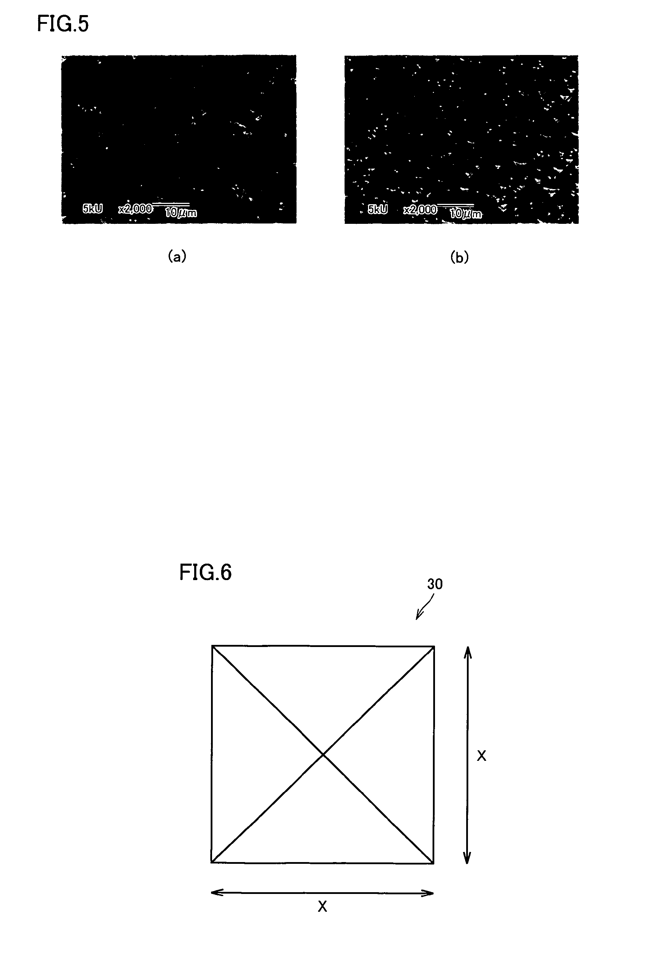

Fig. 5 (a) shows an exemplary SEM image of the light-receiving surface of back electrode type solar cell 1 according to the embodiment fabricated as above. Here, as shown in Fig. 5 (a), it is observed that a textured structure having a concavo-convex shape containing a plurality of pyramidal convex portions with different sizes is formed on the light-receiving surface of back electrode type solar cell 1 according to the embodiment. The average texture side length of the textured structure on the light-receiving surface of back electrode type solar cell 1 according to the embodiment is 11.5 µm. Fig. 5 (b) shows, for comparison purposes, an SEM image of a light-receiving surface of a back electrode type solar cell according to a comparative example having an average texture side length of 4.6 µm.

As referred to herein, the "average texture side length of the textured structure" can be determined by making an SEM observation of a region with an area of 3000 µm² in a given section of the light-receiving surface of a solar cell, selecting five pyramidal convex portions in the order of having a greater texture side length based on the SEM observation, and finding an average value of the texture side lengths of the five convex portions.

Fig. 6 shows a schematic enlarged plan view of one of pyramidal convex portions constituting a textured structure when viewed vertically downward from above. Here, as shown in Fig. 6, a convex portion 30 can be recognized as a rectangular plane whose diagonal intersections form an apex of convex portion 30, wherein a length X of each side of the rectangle is defined as the "texture side length" of convex portion 30.

Next, in order to evaluate surface reflectance of the light-receiving surface (reflectance of the light-receiving surface) of the n-type silicon substrate, samples were fabricated by varying the size of the textured structure on the light-receiving surface of the n-type silicon substrate. The size of the textured structure was adjusted by changing the etching time for the light-receiving surface of the n-type silicon substrate in the above-described manufacturing method. Since the textured structure having a pyramidal concavo-convex shape is formed by etching the light-receiving surface of the n-type silicon substrate, the texture side length of each pyramidal convex portion constituting the textured structure increases as the amount of etching of the light-receiving surface of the n-type silicon substrate is increased.

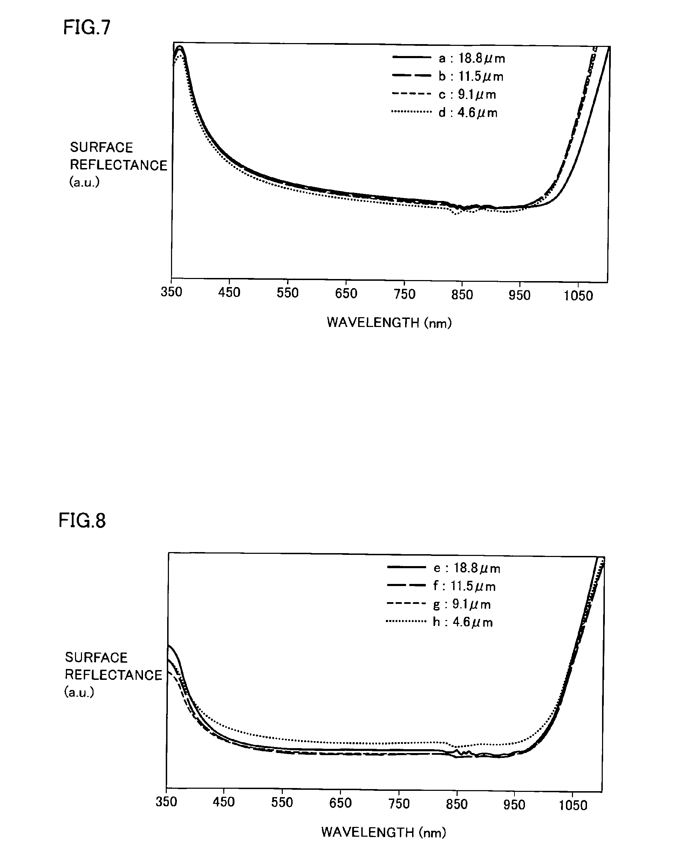

Fig. 7 shows results obtained by measuring surface reflectances of light-receiving surfaces of the samples each obtained by forming a textured structure having a different average texture side length on the light-receiving surface of the n-type silicon substrate. Fig. 7 shows changes in surface reflectance (a. u.) of the light-receiving surface in accordance with changes in the wavelength (nm) of light incident on the light-receiving surface, for each of the samples of n-type silicon substrates including a textured structure having an average texture side length of 18.8 µm, 11.5 µm, 9.1 µm, or 4.6 µm on the light-receiving surface. In Fig. 7, the vertical axis represents surface reflectance (a.u.) of the light-receiving surface, and the horizontal axis represents wavelength (nm) of light incident on the light-receiving surface.

The solid line a shown in Fig. 7 represents changes in surface reflectance of the sample whose average texture side length of the textured structure is 18.8 µm, and the broken line b shown in Fig. 7 represents changes in surface reflectance of the sample whose average texture side length of the textured structure is 11.5 µm. The dashed line c shown in Fig. 7 represents changes in surface reflectance of the sample whose average texture side length of the textured structure is 9.1 µm, and the dotted line d shown in Fig. 7 represents changes in surface reflectance of the sample whose average texture side length of the textured structure is 4.6 µm.

As shown in Fig. 7, it was confirmed that even where the average texture side length of the textured structure on the light-receiving surface of the n-type silicon substrate is varied, there is no significant difference in surface reflectance within the measured range of wavelengths of incident light. Furthermore, samples were fabricated by varying the average texture side length of the textured structure on the light-receiving surface of the n-type silicon substrate in the range from 3 to 24 µm, and changes in surface reflectance were measured for each of the samples. As a result, results similar to the changes shown for a to d in Fig. 7 were obtained without any significant difference.

Fig. 8 shows results obtained by measuring surface reflectances of light-receiving surfaces of back electrode type solar cells each fabricated by forming a light-receiving surface passivation film and an anti-reflection film on any of the samples of n-type silicon substrates used in the measurement shown in Fig. 7.

Here, four types of back electrode type solar cells were used as the back electrode type solar cells for use in the measurement of surface reflectances shown in Fig. 8. Each of the four types of back electrode type solar cells had a structure wherein an n-type silicon substrate including a textured structure having an average texture side length of 18.8 µm, 11.5 µm, 9.1 µm, or 4.6 µm on the light-receiving surface was used, and a light-receiving surface passivation film made of a silicon oxide film and an anti-reflection film made of titanium oxide containing 15 to 35% by mass of phosphorus as phosphorus oxide were stacked in this order on the textured structure.

Fig. 8 shows changes in surface reflectance (a. u.) of the light-receiving surface in accordance with changes in the wavelength (nm) of light incident on the light-receiving surface, for each of the back electrode type solar cells including a textured structure having an average texture side length of 18.8 µm, 11.5 µm, 9.1 µm, or 4.6 µm on the light-receiving surface. In Fig. 8, the vertical axis represents surface reflectance (a.u.) of the light-receiving surface, and the horizontal axis represents wavelength (nm) of light incident on the light-receiving surface.

The solid line e shown in Fig. 8 represents changes in surface reflectance of the back electrode type solar cell whose average texture side length of the textured structure is 18.8 µm, and the broken line f shown in Fig. 8 represents changes in surface reflectance of the back electrode type solar cell whose average texture side length of the textured structure is 11.5 µm. The dashed line g shown in Fig. 8 represents changes in surface reflectance of the back electrode type solar cell whose average texture side length of the textured structure is 9.1 µm, and the dotted line h shown in Fig. 8 represents changes in surface reflectance of the back electrode type solar cell whose average texture side length of the textured structure is 4.6 µm.

As shown in Fig. 8, the back electrode type solar cell whose average texture side length of the textured structure is 4.6 µm, represented by the dotted line h, has surface reflectances higher than those of the other back electrode type solar cells represented by the solid line e, the dashed line g, and the broken line h. In contrast, the surface reflectances of the back electrode type solar cells represented by the solid line e, the dashed line g, and the broken line h are kept low.

Furthermore, back electrode type solar cells were fabricated by varying the average texture side length of the textured structure, and surface reflectances of the back electrode type solar cells were measured in the same manner as described above. As a result, when the average texture side length of the textured structure is 7 to 24 µm, the surface reflectances of the back electrode type solar cells could be kept low, as with the back electrode type solar cells represented by the solid line e, the dashed line g, and the broken line h. In contrast, when the average texture side length of the textured structure is 3 to 6 µm, surface reflectances were high, as with the surface reflectances of the back electrode type solar cell represented by the broken line h. This reveals that the surface reflectances of the light-receiving surface can be kept low when the average texture side length of the textured structure on the light-receiving surface is 7 µm or greater.

Furthermore, attempts to make silicon substrates thinner have been made to reduce manufacturing costs of solar cells. In the method for manufacturing back electrode type solar cell 1 described above, the thickness of n-type silicon substrate 4 before the formation of concavo-convex shape 5 as the textured structure is 100 µm, for example.

Moreover, if n-type silicon substrate 4 becomes too thin at the completion of formation of concavo-convex shape 5 as the textured structure, a decreased yield due to cracking of n-type silicon substrate 4 may become a problem in the subsequent steps. Therefore, the thickness of n-type silicon substrate 4 is preferably 85 µm or larger, and more preferably 90 µm or larger. This means that the amount of etching to form a textured structure (amount of decrease in the thickness of the light-receiving surface of n-type silicon substrate 4) is preferably 15 µm or smaller, and more preferably 10 µm or smaller.

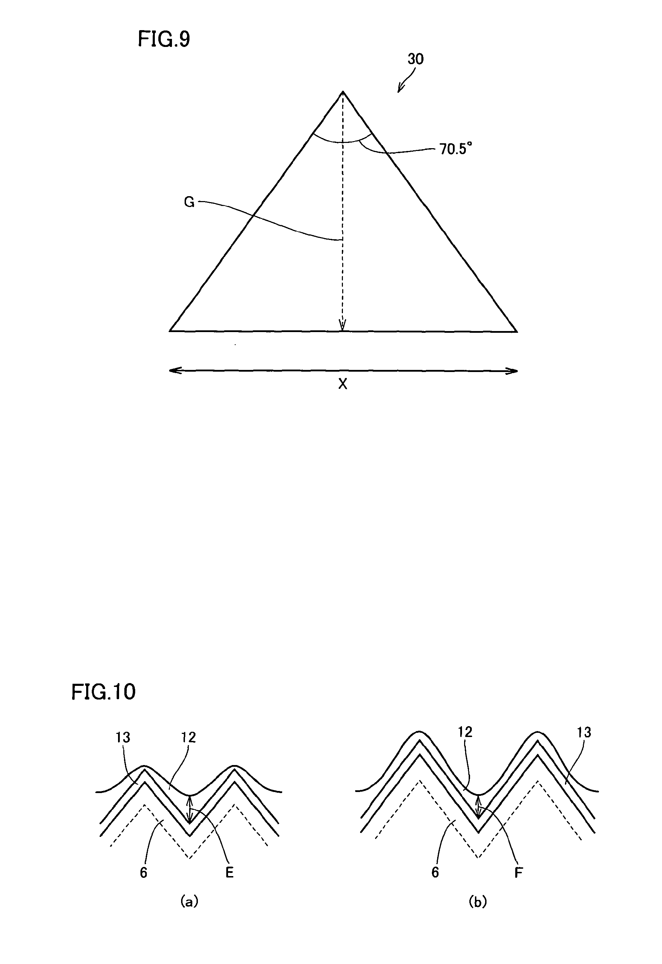

Fig. 9 is a schematic side view of one of convex portions 30 constituting a textured structure having a pyramidal concavo-convex shape. Here, a side surface of convex portion 30 can be recognized as a triangular plane, wherein a height G of the triangle corresponds to the amount of etching at the time of formation of the textured structure, and length X of the base of the triangle corresponds to the texture side length. The angle of the apex of ideal pyramidal convex portion 30 (angle diagonal to the base of the triangle that corresponds to a side surface of convex portion 30) obtained by etching a (100) plane of a silicon single crystal is 70.5°.

Furthermore, when the angle of the apex of ideal pyramidal convex portion 30 is 70.5°, values of X can be calculated using Fig. 9 to be as follows: when G=15, X=21.2; when G=11, X=15.5; when G=10.5, X=14.8; and when G=10, X=14.1. Thus, from the standpoint of suppressing cracking of the silicon substrate during the process, the texture side length is preferably 21 µm or smaller, and more preferably 14 µm or smaller.

It is noted that the light-receiving surface of the n-type silicon substrate of every back electrode type solar cell used in the measurement shown in Fig. 8 has the light-receiving surface diffusion layer formed thereon by using the mixture containing phosphorus pentoxide. Where the light-receiving surface diffusion layer is not formed on the light-receiving surface of an n-type silicon substrate, an anti-reflection film is formed by using a mixture not containing phosphorus pentoxide, and then a silicon oxide film that is to serve as the light-receiving surface passivation film is formed. In this case also, results similar to those shown in Fig. 8 are obtained.

Fig. 10 (a) shows a schematic enlarged cross-sectional view of an exemplary light-receiving surface of a solar cell having a textured structure with a small texture side length, and Fig. 10 (b) shows a schematic enlarged cross-sectional view of an exemplary light-receiving surface of a solar cell having a textured structure with a great texture side length.

With reference to Figs. 10 (a) and (b), a cause of the variations in surface reflectance depending on the size of the texture side length of the textured structure will be considered hereinafter. When anti-reflection film 12 is formed by application and drying of mixture 27 and heat treatment, the concave portion of the textured structure has a section in which mixture 27 is collected, as shown by E in Fig. 10 (a) and by F in Fig. 10 (b), and thus the thickness of that portion of anti-reflection film 12 is large.

In each of regions shown by E in Fig. 10 (a) and F in Fig. 10 (b), the thickness of the titanium oxide film serving as anti-reflection film 12 is 300 to 400 nm, for example. Where the titanium oxide film constituting anti-reflection film 12 having a thickness of around 70 to 100 nm is uniformly formed, the surface reflectance for light with a wavelength around 600 nm is the lowest, owing to an interference effect.

However, as shown in Figs. 10 (a) and (b), where the thickness of anti-reflection film 12 is not uniform, as in the regions near E and F, an interference effect cannot be obtained.

Thus, in the case of the textured structure with a small texture side length as shown in Fig. 10 (a), the depth of the concave portion of the textured structure tends to be shallow, and therefore the proportion of the titanium oxide film serving as anti-reflection film 12 formed in the concave portion of the textured structure on the light-receiving surface of the solar cell tends to be high. As described above, since the titanium oxide film formed in the concave portion of the textured structure has a nonuniform thickness, it is believed that the light-receiving surface of the solar cell tends to have higher reflectance when the proportion of the titanium oxide film formed in the concave portion of the textured structure increases.

For the reason as described above, the height of convex portion 30 of textured structure 5 on which anti-reflection film 12 is provided is preferably higher. To increase the height of convex portion 30, however, it is necessary to increase the amount of etching. If the amount of etching is increased, the thickness of n-type silicon substrate 4 on the bottom portion of textured structure 5 becomes small, which tends to cause cracking of n-type silicon substrate 4. Therefore, the height of concave portion 30 is preferably 5 to 15 µm.

As described above, a solar cell with excellent characteristics can be realized because the surface reflectance of the light-receiving surface can be lowered by defining the length of the texture side length of the textured structure on the light-receiving surface of a solar cell.

While the n-type silicon substrate that is a n-type single crystal silicon substrate has been described above, a p-type silicon substrate that is a p-type single crystal silicon substrate can also be used. When a p-type silicon substrate is used, a p⁺ layer having a p-type impurity diffused therein will serve as the light-receiving surface diffusion layer on the light-receiving surface of the p-type silicon substrate, and a film containing the p-type impurity will serve as the anti-reflection film. The structure is otherwise the same as that described above for the n-type silicon substrate.

When a p-type silicon substrate is used, a total area of the n⁺ layer different in conductivity type from the p-type conductivity is preferably greater than a total area of the p⁺⁺ layer, on the back surface of the p-type silicon substrate. In this case, a greater short-circuit current tends to be obtained.

Moreover, when a p-type silicon substrate is used, the p⁺⁺ layer may be separated in a direction orthogonal to a longitudinal direction of the p⁺⁺ layer in at least one section of the p⁺⁺ layer, on the back surface of the p-type silicon substrate. In this case, the n⁺ layer is formed between the separated p⁺⁺ layers.

Furthermore, when a p-type silicon substrate is used, the n⁺ layer may be separated in the direction orthogonal to the longitudinal direction of the n⁺ layer in at least one section of the n⁺ layer, on the back surface of the p-type silicon substrate. In this case, the p⁺⁺ layer is formed between the separated n⁺ layers.

While the back electrode type solar cell wherein an electrode is formed solely on the back surface of a silicon substrate has been described above, effects similar to those described above will be demonstrated even in the case of a solar cell having a double-sided electrode structure wherein electrodes are formed on both the light-receiving surface and back surface of a silicon substrate, if the light-receiving surface has the same structure as described above.

### INDUSTRIAL APPLICABILITY

The solar cells according to the present invention can find wide application in the general field of solar cells.

### REFERENCE SIGNS LIST

1: back electrode type solar cell; 2: electrode for n-type; 3: electrode for p-type; 4: n-type silicon substrate; 5: concavo-convex shape; 6: n⁺ layer; 8: second back surface passivation film; 9: n⁺⁺ layer; 10: p⁺ layer; 11: first back surface passivation film; 12: anti-reflection film; 13: light-receiving surface passivation film; 14: back surface passivation film; 21: texturing mask; 22: diffusion mask; 23: diffusion mask; 24: silicon oxide film; 25: diffusion mask; 27: mixture; 30: convex portion

## Claims

1. A solar cell (1) comprising:
a silicon substrate (4);
a textured structure (5) provided on a light-receiving surface of said silicon substrate (4);
a light-receiving surface passivation film (13) provided on said textured structure (5); and
an anti-reflection film (12) provided on said light-receiving surface passivation film (13), an average texture side length of said textured structure (5) being 7 µm or greater.

2. The solar cell (1) according to claim 1, wherein said average texture side length is 21 µm or smaller.

3. The solar cell (1) according to claim 1 or 2, wherein said average texture side length is 14 µm or smaller.

4. The solar cell (1) according to any of claims 1 to 3, wherein a convex portion of said textured structure (5) has a height of 5 to 15 µm.

5. The solar cell (1) according to any of claims 1 to 4, wherein said anti-reflection film is thick near a bottom portion of said textured structure.

6. The solar cell (1) according to any of claims 1 to 5, wherein said anti-reflection film (12) is titanium oxide.

7. The solar cell (1) according to claim 6, wherein said anti-reflection film (12) contains 15 to 35% by mass of phosphorus as phosphorus oxide.

8. The solar cell (1) according to any of claims 1 to 7, wherein said light-receiving surface passivation film (13) is silicon oxide.

9. The solar cell (1) according to any of claims 1 to 8, wherein a light-receiving surface diffusion layer (6) is formed on the light-receiving surface of said silicon substrate (4).
